(19)

**Europäisches Patentamt**
**European Patent Office**
**Office européen des brevets**

(11) **EP 4 268 346 B1**

(12) **EUROPEAN PATENT SPECIFICATION**

(45) Date of publication and mention
of the grant of the patent:
**25.12.2024 Bulletin 2024/52**

(21) Application number: **21840917.5**

(22) Date of filing: **20.12.2021**

(51) International Patent Classification (IPC):
**H02J 7/00** $^{(2006.01)}$

(52) Cooperative Patent Classification (CPC):
**H02J 7/0016; H02J 7/0047**

(86) International application number:
**PCT/EP2021/086702**

(87) International publication number:
**WO 2022/136220 (30.06.2022 Gazette 2022/26)**

(54) **A SWITCHED-CAPACITOR BALANCING AND CHARACTERIZATION METHOD AND SYSTEM**

VERFAHREN UND SYSTEM ZUM AUSGLEICH UND ZUR CHARAKTERISIERUNG EINES SCHALTKONDENSATORS

PROCÉDÉ D'ÉQUILIBRAGE ET DE CARACTÉRISATION DE CONDENSATEUR COMMUTÉ ET SYSTÈME

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **23.12.2020 EP 20216994**

(43) Date of publication of application:
**01.11.2023 Bulletin 2023/44**

(73) Proprietor: **Danmarks Tekniske Universitet**
**2800 Kongens Lyngby (DK)**

(72) Inventors:
• **JØRGENSEN, Ivan, H., H.**
**2800 Kongens Lyngby (DK)**

• **LLIMÓS MUNTAL, Pere**
**2800 Kongens Lyngby (DK)**
• **LARSEN, Dennis, Øland**
**2800 Kongens Lyngby (DK)**
• **SOUVIGNET, Thomas**
**2800 Kongens Lyngby (DK)**
• **PAUSAS, Guifré, Vendrell**
**2800 Kongens Lyngby (DK)**

(74) Representative: **Høiberg P/S**
**Adelgade 12**
**1304 Copenhagen K (DK)**

(56) References cited:
**WO-A1-2020/142398     US-A1- 2002 190 692**
**US-A1- 2011 163 728     US-A1- 2016 105 042**

## Description

The present disclosure relates to a method for simultaneously balancing and characterizing a stack of battery cells using a switched-capacitor system.

## Background

Systems of stacked battery cells are often used to power many applications, including electrical cars. The performance of systems with stacked battery cells can be enhanced by balancing the voltage between the battery cells as these have different performance characteristics, e.g., some are considered better performing than others. If no balancing of the battery stack is done, the overall operation time of the battery stack will be limited by the performance of the battery cell with the poorest performance. 'Performance' of a battery cell may refer to the charge stored in the battery cell and the internal impedance of the battery cell.

Today balancing of the battery cells is done after charging and when the battery cells are not in use. The most common battery balance technique is passive balancing. This technique drains the charge of all the better battery cells to align its performance to the poorest performing one.

Passive balancing can be said to have a power efficiency of 0 %. This limits battery lifetime to the lifetime of the poorest performing battery cell, e.g., it also reduces the maximum mileage in electrical cars.

Active balancing - on the other hand - moves charge from the well performing battery cells to the poorest performing battery cell, thereby improving the performance of the "bad" battery cell yielding longer battery life time for the stack. Also, the power efficiency using active balancing can be in the 90's %. Many solutions exist for active balancing, such as the one disclosed in document US-A-2002190692, which is based on a switched-capacitor arrangement.

In order to improve the performance of the battery stack it is further desired to know the state of the battery cells (such as internal ac-resistances). For this, one needs to measure the electrical characteristics of the battery cell. This can be done in two ways, either injecting a small sinusoid or injecting a noise signal into each battery cell and then estimating the ac-characteristics by measuring the ac voltage or noise voltage across the battery cells, as disclosed for example, in document WO-A-2020142398.

There are several inconveniences with the active balancing and the measurements of the characteristics of the battery cells in the conventional implementations. One is that there needs to be a unit for generating stimuli to the battery cells. Another is that the stimuli may cause electromagnetic interference (EMI).

## Summary

The present disclosure provides a method and system for active balancing of a plurality of stacked battery cells, wherein a switched-capacitor topology is used both for the balancing and for simultaneously providing characterization signals to the plurality of stacked battery cells, using the same switched-capacitor topology. This may have several advantages. By using the topology of the capacitors and the plurality of switches arranged in a ladder structure both for the active balancing and simultaneous provision of characterization signals for the stacked battery cells by applying true random or pseudo-random control signals to the plurality of switches, the characterization can be done as an integral part of the active balancing process, without causing the EMI that an external signal would do. As an example, by knowing the AC impedance of the battery cells during the balancing, more accurate balancing may be achieved. The proposed method also enables estimation of State-of-Charge (SOC) and State-of-Health (SOH), two important metrics in battery packs. SOC refers to the remaining charge in a cell as a percentage of the charge contained by the cell when it is full. SOH may refer to the change in the amount of charge that the cells can hold as they age, or to a quantification of the health of the cell as a function of its increasing internal resistance as it ages. The estimation of SOC and SOH can be done based on the characterization. Moreover, the proposed method may enable balancing during operation. One objective of the present disclosure is to provide a method and a system for balancing and characterizing battery cells or stack of battery cells. The method relies on a switched-capacitor system, where the switches are controlled by a true random or pseudo random sequence.

The present disclosure relates to, according to a first embodiment, a switched-capacitor balancing and characterization system for balancing and characterization of a plurality of stacked battery cells, the switched-capacitor balancing and characterizing system according to claim 1. In detail, the system comprises:

- at least one capacitor connectable to the plurality of stacked battery cells, wherein the at least one capacitor is adapted to move charge to and from the plurality of stacked battery cells;
- a plurality of switches configured to connect and disconnect the at least one capacitor to the plurality of stacked battery cells; and
- a processing unit configured to control the plurality of switches by applying true random or pseudo-random control signals to the plurality of switches, wherein switching period lengths of the control signals have a random component, thereby simultaneously performing active balancing of the plurality of stacked battery cells and providing characterization voltage and/or current at terminals of the plurality of stacked battery cells.

By using the capacitors and switches to open and close electrical connections between the terminals of the battery cells and the capacitors, and applying true random or pseudo-random control signals to the switches themselves it is possible to achieve simultaneous balancing and characterization of the battery cells. Charge is moved from the more charged battery cells to the less charged battery cells to achieve balancing. At the same time the random sequence of the clock used for the switches makes it possible to generate measurable signals on the battery cells for battery characterization. This way simultaneous balancing and characterization of the batteries is achieved. According to one embodiment, the switches are switched according to a predefined sequence, whereas the lengths of the switching periods have a random component. The inventors have realized that when operating the switched-capacitor topology in this manner, the active balancing still works with the random component of the length of the switching period, and, at the same time, the random component of the length of the switching period can provide a noise signal to each battery cell, which can be used for ac-characteristics by measuring the ac voltage or noise voltage across the battery cells.

The method can be enabled and disabled according to certain criteria or according to a predefined plan of employment. In one embodiment the switched capacitor balancing and characterization system is configured to operate in a first mode, wherein the switches are clocked using a predefined duty cycle, such as 50%, and in a second mode, wherein the true random or pseudo-random control signals are applied to the plurality of switches. It may thus be useful in certain embodiments to operate the switched capacitor system as a conventional system for active balancing, and then switch to the second configuration, which may also be referred to as characterization configuration. The operation modes may be controlled by the processing unit.

Further embodiments may comprise the switched capacitor balancing and characterization system, wherein the processing unit is configured to, in a boost switching scheme, configure the plurality of switches to connect the capacitor to at least two serially connected battery cells. The boost switching scheme may be particularly useful towards the end of the active balancing process. When the difference in voltage between the battery cells become low, i.e. the voltages of the battery cells align, the characterization signal may accordingly be low, which can make it more difficult to measure the AC characteristics on the battery cells.

As will be described in further detail, the true random or pseudo-random control signals can be generated in a number of embodiments. Further embodiments may therefore comprise a ring oscillator, or a relaxation oscillator, or a crystal oscillator, or a pseudo-random sequence generator, or a random noise generator, or a sigma-delta converter or any other suitable means for generating the control signals to the plurality of switches.

The presently disclosed switched-capacitor balancing and characterization system may be provided as a system that can be connected to a plurality of stacked battery cells, for example, a plurality of stacked battery cells in an electric vehicle. The system may comprise the configurable switched-capacitor circuitry, the processing unit and connectors for connecting the system to an existing battery system or package comprising a plurality of stacked battery cells.

In order to provide the characterization the system may further comprise a voltage measurement and/or a current measurement device for measuring a voltage or current of one or more of the plurality of stacked battery cells, thereby achieving characterization of the plurality of stacked battery cells.

In a further embodiment, the presently disclosed switched-capacitor balancing and characterization system is provided as a battery system with integrated balancing and characterizing capabilities. In one embodiment, the battery system comprises:

- a plurality of stacked battery cells;
- at least one capacitor connectable to the plurality of stacked battery cells, wherein the at least one capacitor is adapted to move charge to and from the plurality of stacked battery cells;
- a plurality of switches configured to connect and disconnect the at least one capacitor to the plurality of stacked battery cells; and

a processing unit configured to control the plurality of switches by applying true random or pseudo-random control signals to the plurality of switches.

By using the capacitors and switches to be able to open and close electrical connections between the terminals of the battery cells and the capacitors, and applying true random or pseudo-random control signal to the switches themselves, it is possible to achieve simultaneous balancing and characterization of the plurality of stacked battery cells. Charge is moved from the more charged battery cells to the less charged battery cells achieving balancing and at the same time the random sequence of the clock used for the switches makes it possible to generate the measurable signals on the battery cells for battery characterization, thereby achieving simultaneous balancing and characterization of the battery cells.

The present disclosure further relates to a method according to claim 14. In detail the method is for balancing and characterizing a plurality of stacked battery cells by using a switched-capacitor balancing and characterizing system comprising at least one capacitor connectable to the plurality of stacked battery cells; and a plurality of switches configurable to connect and disconnect the at least one capacitor to the plurality of stacked battery cells, the method comprising the steps of:

- applying true random or pseudo-random control signals, wherein switching period lengths of the control signals have a random component, to the plurality of switches, thereby simultaneously performing active balancing of the plurality of stacked battery cells and providing characterization voltage and/or current at the terminals of the plurality of stacked battery cells;
- characterizing the plurality of stacked battery cells by analyzing at least one characteristic of an electrical signal of the plurality of stacked battery cells.

A person skilled in the art will recognize that the presently disclosed method may be performed using any embodiment of the presently disclosed switched-capacitor balancing and characterization system for balancing and characterization of a plurality of stacked battery cells, and or using any embodiment of the presently disclosed battery system. Accordingly, the method may perform any step which the presently disclosed switched-capacitor balancing and characterization system and /or battery system is configured to perform.

The invention further relates to a computer program having instructions which when executed by a computing device or computing system cause the computing device or system to carry out any embodiment of the presently disclosed method for for balancing and characterizing a plurality of stacked battery cells by using a switched-capacitor balancing and characterizing system. Computer program in this context shall be construed broadly and include, for example, programs to be run on a PC or software adapted to run as a part of a systems of stacked battery cells.

### Description of the drawings

The invention will in the following be described with reference to the accompanying drawings, which are exemplary and not limiting to the presently disclosed switched-capacitor balancing and characterization method and system.

Fig. 1 shows a schematic view of an embodiment of the presently disclosed switched-capacitor balancing and characterization system (100) for balancing and characterization of a plurality of stacked battery cells

Fig. 2 shows a schematic view of an embodiment of the presently disclosed battery system (200).

Fig. 3A, 3B, 3C and 3D show an example of a "boost" scheme in which one or more stacked capacitors are charged on two battery cells. In this specific embodiment there is only one capacitor and only two battery cells.

Fig. 4 shows a schematic view of an embodiment of the presently disclosed switched-capacitor balancing and characterization system where the number of stacked battery cells is more than two and the number of stacked capacitors is more than one.

Fig. 5A, 5B, 5C and 5C show an example of a "boost" scheme in which one or more stacked capacitors are charged on two battery cells. In this embodiment there is more than one capacitor and more than two battery cells.

Fig. 6 shows an example of characterization of a device under test (DUT) where the characterization system uses a Fourier transform to characterize the plurality of stacked batteries

Fig. 7 shows an exemplary implementation of a unit for generating clock signals for the switches.

Fig. 8 shows a schematic diagram of an embodiment of the presently disclosed method for balancing and characterizing a plurality of stacked battery cells by using a switched-capacitor balancing and characterizing system.

Fig. 9A and 9B show an embodiment of a balancing sequence in a non-boost scheme, wherein the flying capacitors are charged on one battery cell and discharged on another battery cell.

Fig. 10A, 10B, 10C and 10D show an embodiment of a boosting scheme sequence, wherein no flying capacitor is shorted.

### Detailed description of the invention

The present disclosure relates to a switched-capacitor balancing and characterization system for balancing and characterization of a plurality of stacked battery cells. The switched-capacitor balancing and characterizing system comprises at least one capacitor connectable to the plurality of stacked battery cells, wherein the at least one capacitor is adapted to move charge to and from the plurality of stacked battery cells; and a plurality of switches configured to connect and disconnect the at least one capacitor to the plurality of stacked battery cells. The system further comprises a processing unit configured to control the plurality of switches. Preferably the system is configured to generate true random or pseudo-random control signals to the plurality of switches. This may simultaneously perform active balancing of the plurality of stacked battery cells and provide characterization signals to the plurality of stacked battery cells.

'Stacked battery cells' in the present disclosure shall be construed broadly and refer to any configuration of a plurality of battery cells, wherein each battery cell may be connected to one or more of the other battery cells in various configurations, and wherein active balancing is relevant. As an example a 'plurality of stacked battery cells' may comprise a number of serially connected battery cells, but also covers a configuration of one battery comprising a number of battery cells. The plurality of stacked battery cells may be serially connected. However groups of serially connected battery cells may be connected in parallel.

The present disclosure further relates to, in one embodiment, a switched capacitor balancing and characterization system, wherein the switched capacitor balancing and characterization system is configured to perform simultaneous balancing and characterization of the plurality of the stacked battery cells. 'Simultaneously' in the present disclosure shall be construed broadly and refer to balancing and characterization performed with the same circuit and at the same time.

The present disclosure further relates to, in one embodiment, a switched capacitor balancing and characterization system, wherein the switched capacitor balancing and characterization system is configured to perform balancing and characterization of the plurality of the stacked battery cells during the operation of the plurality of the stacked battery cells. Balancing and characterization can thus be performed separately from operation, in an ad-hoc balancing and characterization phase or it may be performed during operation of the battery cells, that is when the battery cells are used to power their load and the load is configured to function normally during its operation.

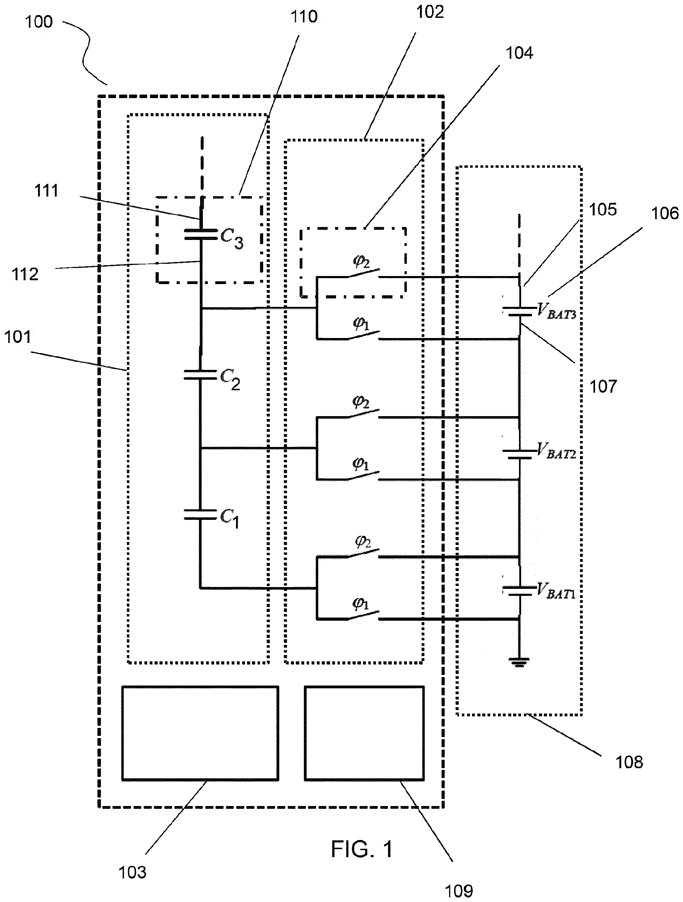

Fig. 1 shows a schematic diagram of one embodiment of the switched-capacitor balancing and characterization system (100) for balancing and characterization of a plurality of stacked battery cells (108). In the example of fig. 1 there are three serially connected capacitors ($C_1$, $C_2$, $C_3$) (110).The system thus comprises a unit (101) of at least one capacitor (101) and a plurality of switches (102). One of the plurality of switches is shown as (104) ($\varphi_1$, $\varphi_2$) and one capacitor of the at least one capacitors is shown in (110) ($C_3$). One battery cell (106) of the plurality of battery cells has an upper terminal (105) and lower terminal (107). The switched-capacitor balancing and characterization system (100) comprises a processing unit (103) configured to control the plurality of switches by applying true random or pseudo-random control signals to the plurality of switches (102). The switched-capacitor balancing and characterization system (100) is coupled to the plurality of stacked battery cells (108). The plurality of battery cells, the capacitors and the plurality of switches are arranged in a ladder structure. Each capacitor has an upper terminal (111) and a lower terminal (112). As can be seen each node between two of the capacitors (for example the node between $C_2$ and $C_3$) can be connected to the upper terminal (105) and lower terminal (107) of a battery cell ($V_{BAT3}$ in the example), by configuration of the plurality of switches. The switched-capacitor balancing and characterization system (100) of the example further comprises a characterization unit (109) configured to characterize the AC impedance of the battery cells.

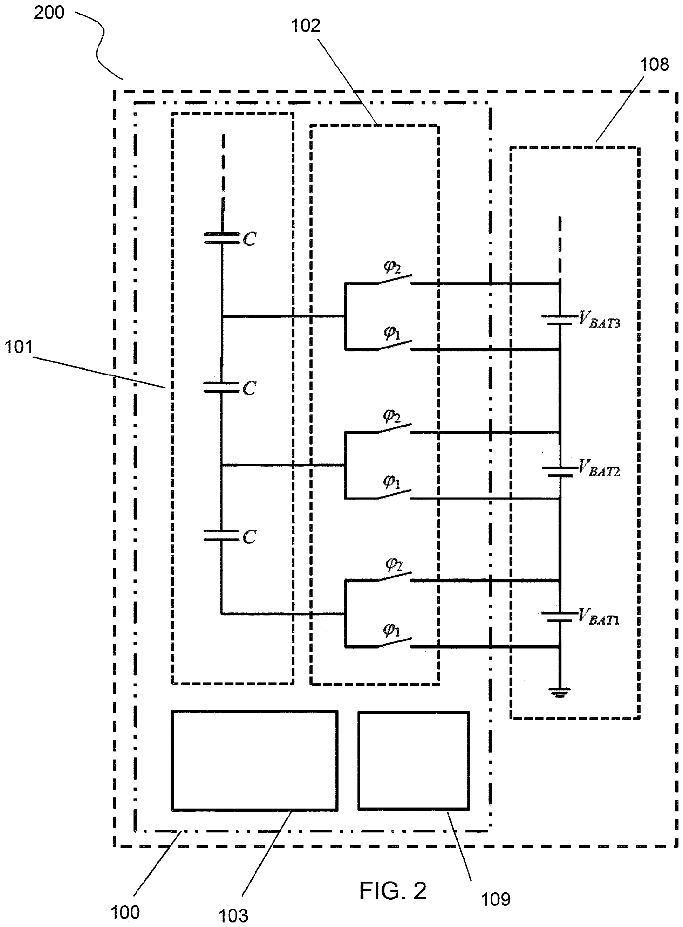

Fig. 2 shows one embodiment of the battery system (200) comprising a plurality of stacked battery cells (108), at least one capacitor (101) connectable to the plurality of stacked battery cells (108), a plurality of switches (102) configured to connect and disconnect the at least one capacitor to the plurality of stacked battery cells (108), a processing unit (103) configured to control the plurality of switches by applying true random or pseudo-random control signals to the plurality of switches, thereby simultaneously performing active balancing of the plurality of stacked battery cells and providing characterization signals to the plurality of stacked battery cells.

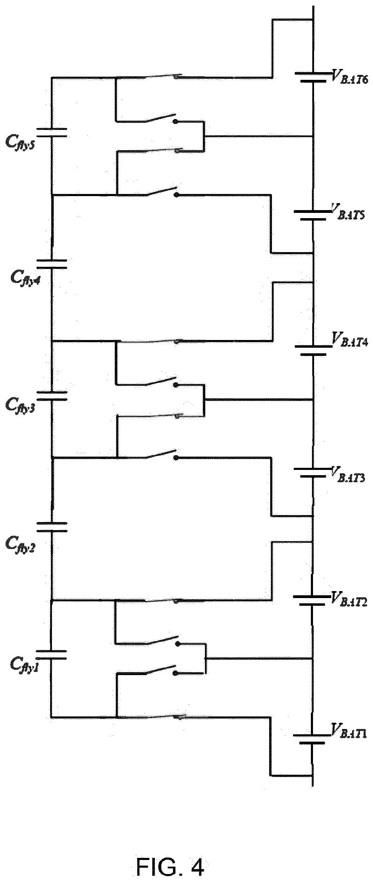

Fig. 4 shows an embodiment of the switched-capacitor balancing and characterization system for balancing and characterization of a plurality of stacked battery cells, where the plurality of stacked battery cells is more than two and the at least one capacitor is more than one. The plurality of battery cells, the capacitors and the plurality of switches are arranged in a ladder structure. A person skilled in the art would recognize that the presently disclosed switched-capacitor balancing and characterization system can operate with any suitable number of battery cells and capacitors.

### Boost scheme

Towards the end of a balancing process the voltage difference between the battery cells in the plurality of battery cells is small and this may result in very small noise characterization signals on the battery cells. This can make it problematic to characterize the battery cells because the AC voltage to be measured across each battery cell is small. In order to overcome this problem, the present disclosure identifies a so called 'boost scheme'. In the boost scheme each flying capacitor is charged with a stack of a pair or more of battery cells, this way obtaining a larger charge flow from the mostly charged battery cells to the least charged battery cells, obtaining a fast balancing but also obtaining a larger AC voltage across each battery cells, which facilitates characterization.

The boost scheme is not necessarily limited to be used with the presently disclosed combined active balancing and characterization. Hence, the present disclosure further relates to a switched-capacitor balancing system comprising:

- a plurality of stacked battery cells;
- at least one capacitor connectable to the plurality of stacked battery cells, wherein the at least one capacitor is adapted to move charge to and from the plurality of stacked battery cells;
- a plurality of switches configured to connect and disconnect the at least one capacitor to the plurality of stacked battery cells; and

a processing unit configured to, in a boost switching scheme, configure the plurality of switches to connect one capacitor to at least two serially connected battery cells. The processing unit may be further configured to perform any additional step related to the boost scheme, as described in the present disclosure.

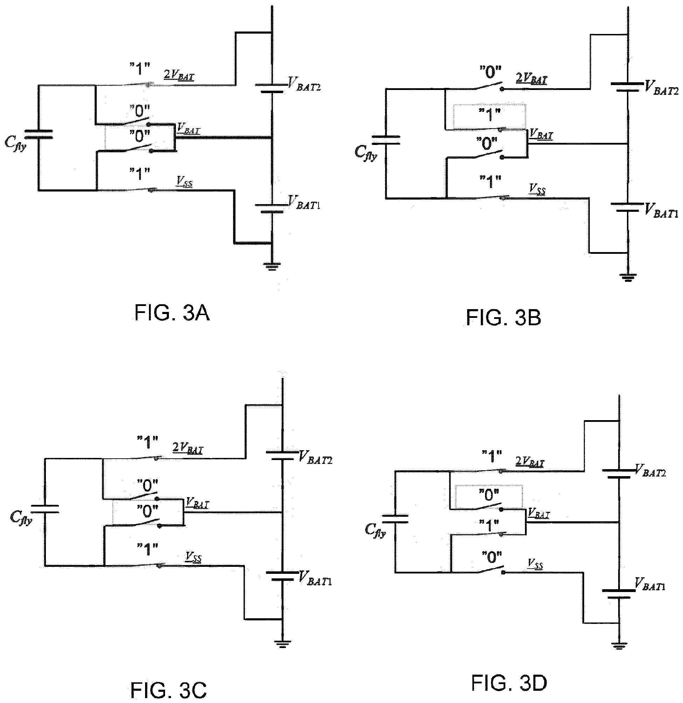

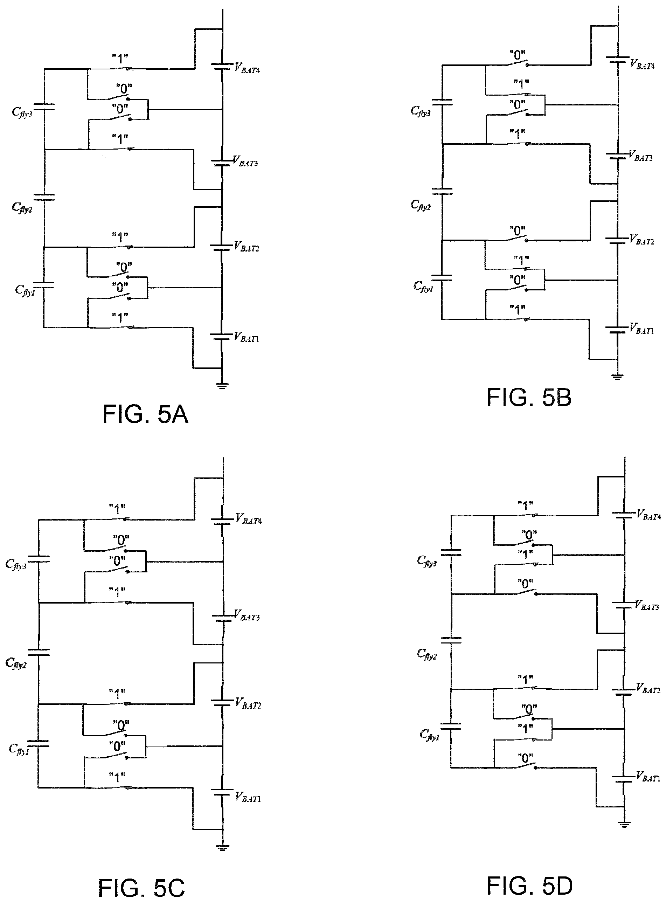

The present disclosure further relates to, in one embodiment, a switched capacitor balancing and characterization system, wherein the processing unit is configured to, in a boost switching scheme, configure the plurality of switches to connect the capacitor to at least two serially connected battery cells. This configuration is shown as an example in Fig 3A and 3C for the case of a battery stack of two battery cells and in Fig 5A and 5C for the case of more than two battery cells in the stack of battery cells. By connecting at some given point of time the flying capacitor to at least two battery cells, the capacitor can be charged faster (boost scheme) and it can at some later point of time release charge faster to the battery cell that is being charged, as shown in Fig. 3B and 3D for the case of only two battery cells in the battery stack and in Fig. 5B and 5D for the case of more than two battery cells in the battery cells stack.

As stated above, one example of the boost scheme is shown in fig 3A, 3B, 3C, 3D. The main sequence of the switch configurations start from the configuration shown in fig 3A, followed by fig. 3B, followed by fig. 3C, followed by fig. 3D. The random clock is preferably applied on top of the given sequence to obtain a true or pseudo randomization of the duration of each steps of the sequence. In the embodiment shown in the fig. 3A, 3B, 3C, 3D, the capacitor is charged at given steps by two battery cells. This way the flying capacitor is, in a first step, charged with at least two battery cells, then the charge is released to one battery cell in a second step, in a third step the flying capacitor is charged again by at least two battery cells and in a final step the second battery cell is charged from the flying capacitor. This mode can be run with a traditional predefined clock duty cycle of, for example, 50% or it can be run with a clock based on a true random or pseudo random or noise signal, achieving a random or pseudo random or noisy duration of each step, achieving this way not only balancing, but also achieving the characterization of the battery cells based on measurements of the random signal at the output of the battery cells.

In one embodiment of the switched capacitor balancing and characterization system the processing unit is configured to configure the plurality of switches such that the capacitor is subsequently discharged to one of the two serially connected battery cells. This is shown as an example in Fig 3B and 3D, where the stacked battery cells are only two, or, in another example, in Fig 5B and 5D, where the stacked battery cells are more than two.

The present disclosure further relates to, in one embodiment, a switched capacitor balancing and characterization system, wherein the processing unit is configured to configure the plurality of switches such that the capacitor is charged by at least three serially connected battery cells.

In one embodiment of the switched capacitor balancing and characterization system, the processing unit is configured to configure the plurality of switches such that the capacitor after each charge is alternatively discharged to the serially connected battery cells. An example of this is shown in Fig 3B and 3D for the case of two battery cells, and in Fig 5B and 5D for the case of more than two battery cells. From the figures it is noted that the flying capacitors, after being previously charged by one or two or more battery cells, release its/their charge to one battery cell only. Whenever the flying capacitor is, during its charging phase, charged by two or more battery cells, the boost scheme is implemented, which is particularly beneficial towards the end of the balancing when the voltages of the different battery cells are very similar to each other.

The present disclosure further relates to, in one embodiment, a switched capacitor balancing and characterization system, wherein the switched capacitor balancing and characterization system is configured to operate in a first charging configuration, wherein each of the capacitors is alternatively connected to two neighboring serially connected battery cells, and, in the boost switching scheme, charging the capacitor using two or more serially connected battery cells. This is shown as an example in Fig 5A and 5C, where the flying capacitors are charged using two battery cells in the first charging configuration, and in Fig 5B and Fig 5D where the charge is transferred from the flying capacitor to one battery cell.

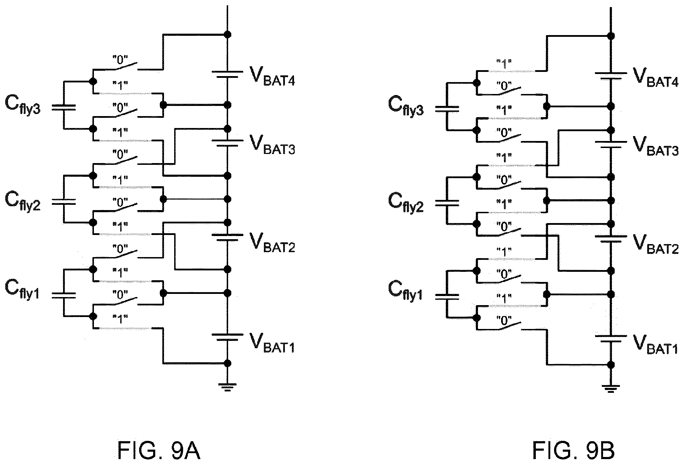

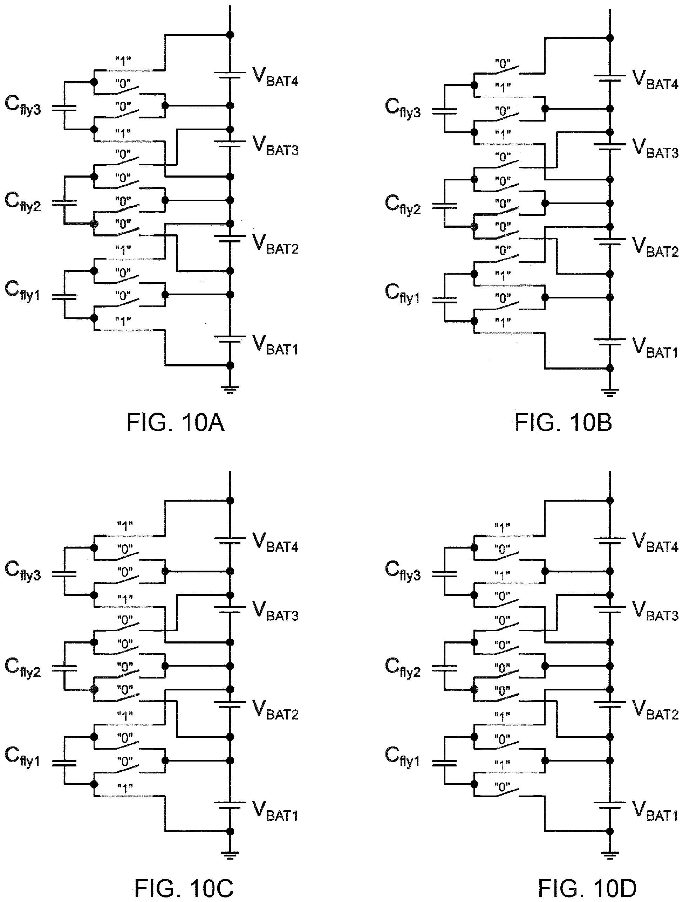

Another embodiment of the boosting scheme sequence is shown in Fig 10A, 10B, 10C, 10D. In this embodiment no flying capacitor is shorted. The circuit described in this embodiment (Fig. 10A-D) could be run, in another embodiment, without boosting scheme according to the sequence shown in Fig. 9A and 9B. Balancing without boost is achieved in the embodiment shown if Fig 9A and 9B. Balancing with boost, but without need of shorting any flying capacitor, is achieved in the embodiment shown in Fig. 10A-D. The embodiments shown in Fig 9A-B and 10A-D comprise more switches than the embodiments shown in Fig. 3A-D, Fig. 4 and Fig. 5A-D and, in a boost-scheme, do not require any flying capacitor to be shorted at any step of the sequence.

*Structural details of the circuit*

The operation of moving the charge across the battery cells of the battery cell stack to even the differences between the battery cells is referred to as balancing and it is obtained by moving charge from the more charged battery cells to the less charged battery cells, using the flying capacitors as temporary charge deposits, which are alternatively charged by one or more battery cells and discharged on a battery cell. That is obtained by connecting the flying capacitors to one battery cell, or, in the boost scheme to two or more battery cells, and then connecting the flying capacitor to one battery cell at the time transferring the charge from the previously charged flying capacitor to each battery cell at the time. This is achieved by periodically changing the connections between the upper and lower terminal of the flying capacitors and the upper and lower terminals of the battery cells using the plurality of switches. The processing unit may control the switches to obtain the required sequence and achieve balancing of the battery cells. The configuration of the electrical connections of the circuits is described below.

The present disclosure further relates to, according to one embodiment, a switched-capacitor balancing and characterization system for balancing and characterization of a plurality of stacked battery cells, wherein:

- the number of the plurality of stacked battery cells is N, wherein the lowest battery cell corresponds to the lowest number 1 and the upmost battery cell corresponds to the highest number N and a generic battery cell corresponds to number n comprised between 1 and N;
- the number of the plurality of flying capacitors is N-1, wherein the capacitors are also stacked and wherein the lowest number 1 corresponds to the lowest capacitor and the upmost number N-1 corresponds to the upmost capacitor and the generic capacitor corresponds to the generic number n comprised between 1 and N-1;

Fig. 3A, 3B, 3C and 3D show an example of a switched-capacitor balancing and characterization system where the number of battery cells is N = 2 and the number of flying capacitors is N-1 = 1. From the figures it is noted how the upper and lower terminals of the battery cells can be connected via the switch to the terminals of the flying capacitor in different configurations that depend on the different steps that the processing unit is programmed to have the circuit perform. In particular fig. 3A and 3C are showing the configuration of the switches during charging of the flying capacitor in a boost mode. In a non-boost mode the charging of the flying capacitor is done using only one battery cell. Fig 3B and 3D are showing configuration of the switches where the flying capacitor discharges its charge to one battery cell. Fig 5A, 5B, 5C and 5D show a more general configuration where the number of battery cells is more than two and the processing unit is configured to couple the battery cells with the flying capacitors. Fig 3A-D and Fig. 5A-D in particular show an ordered sequence that is implementing a boost scheme.

Preferably, each battery cell has a lower terminal and an upper terminal; each flying capacitor has a lower terminal and an upper terminal; and each switch can close or open an electrical connection between one of the lower and upper terminals of the flying capacitors and one of the lower and upper terminals of the stacked battery cells.

According to one embodiment

- the lower terminal of a first stacked battery cell is connected to the ground terminal of the system;
- the upper terminal of each stacked battery cell i is connected to the lower terminal of stack battery cell i-1;
- the lower terminal of each flying capacitor i is connected to either the lower terminal of the stacked battery cell i or to the upper terminal of the stacked battery cell i depending on the configuration of the plurality of switches; and
- the upper terminal of each flying capacitor n is connected to either the lower terminal of battery cell i+1 or the upper terminal of battery cell i+1 depending on the configuration of the switches.

The plurality of stacked battery cells and the plurality of capacitors are, preferably, arranged in a ladder structure. An example of such a structure is provided in Fig. 4 which shows one embodiment of the present disclosure relating to a switched capacitor balancing and characterization system. In the embodiment shown in fig. 4, the upper terminal of battery cell 1 is connected to the lower terminal of battery cell 2 and in general the upper terminal of battery cell n is connected to the lower terminal of battery cell n+1. In a similar fashion the upper terminal of flying capacitor 1 is connected to the lower terminal of flying capacitor 2 and in general the upper terminal of flying capacitor i is connected to the lower terminal of flying capacitor i+1. The connection between the flying capacitors and the battery cells is instead configurable and it is dependent on the configuration of the switches, which are programmed to open and close the connections between the flying capacitors and the battery cells so as to even the charge between all battery cells during a sequence of configurations, hence performing the operation of balancing. The sequence of balancing can, in a first mode, be run with a 50% duty cycle clock driving the switches thus obtaining only balancing. In a second mode, a true random or pseudo random or noise sequence can be applied to the clock of the switches, thus producing, together with balancing, a measurable voltage at the output of the battery cells which can be measured in order to obtain an AC-characterization of the battery cells, hence achieving simultaneously balancing and characterization of the battery cells.

The present disclosure further relates to, according to one embodiment, a switched capacitor balancing and characterization system, comprising N serially connected battery cells and N-1 serially connected capacitors, wherein the plurality of switches are configurable to connect each of the N-1 serially connected capacitors to at least two individual battery cells. An embodiment of such a structure is shown in fig. 4 where N = 6. The parameter N is not limited to 6 but can be any suitable parameter.

In one embodiment of the presently disclosed switched capacitor balancing and characterization system, the processing unit is configured to alternatively connect each of the capacitors to two neighboring serially connected battery cells to even the charge over the two neighboring battery cells over time. In a normal scheme, i.e. in a non-boost scheme, the processing unit may be programmed to connect the flying capacitor to the most charged battery cell only of each pair of battery cells during flying capacitor charge. In the discharge phase the flying capacitor is connected to the least charged battery cell. The user does not necessarily need to know which battery cell is the mostly charged but the connection to each single battery cell of each pair has to be alternated, so as to guarantee an effective movement of charge from the mostly charged battery cell of the pair to the least charged battery cell of the pair. This normal or non-boost scheme can effectively be used especially at the beginning of the balancing process, whereas at the end of the balancing process the boost scheme is preferred. In the boost scheme the flying capacitor is charged, during flying capacitor charging phase, by two or more battery cells.

*Battery System*

The present disclosure further relates to a battery system comprising:

- a plurality of stacked battery cells;
- at least one capacitor connectable to the plurality of stacked battery cells, wherein the at least one capacitor is adapted to move charge to and from the plurality of stacked battery cells;
- a plurality of switches configured to connect and disconnect the at least one capacitor to the plurality of stacked battery cells; and
- a processing unit configured to control the plurality of switches by applying true random or pseudo-random control signals to the plurality of switches, thereby simultaneously performing active balancing of the plurality of stacked battery cells and providing characterization signals to the plurality of stacked battery cells.

Fig. 2 shows a schematic diagram of one embodiment of the battery system (200) comprising the switched capacitor balancing and characterization system (100). In such an embodiment of the battery system the battery cells are included together with the needed circuitry for simultaneous balancing and characterization, composed by the flying capacitors (101), the switches (102) and the processing unit (103).

The battery system can perform simultaneous balancing and characterization of the battery cells, using the programmed sequences and the true random or pseudo random clock generated by the processing unit. The battery system is altogether capable of performing the same functionality as the switched capacitor balancing and characterization system with the difference that the battery system comprises the battery cells within, whereas the switched capacitor balancing and characterization system does not contain any battery cell and is connected to an external stack of battery cells.

*Method for balancing and characterizing a plurality of stacked battery cells*

The present disclosure further relates to a method for balancing and characterizing a plurality of stacked battery cells by using a switched-capacitor balancing and characterizing system comprising at least one capacitor connectable to the plurality of stacked battery cells; and a plurality of switches configurable to connect and disconnect the at least one capacitor to the plurality of stacked battery cells, the method comprising the steps of:

- applying true random or pseudo-random control signals to the plurality of switches, thereby simultaneously performing active balancing of the plurality of stacked battery cells and providing characterization signals to the plurality of stacked battery cells;
- characterizing the plurality of stacked battery cells by analyzing at least one characteristic of an electrical signal of the plurality of stacked battery cells.

The method for balancing and characterizing a plurality of stacked battery cells may use any variant of the presently disclosed switched capacitor balancing and characterization system (100).

A person skilled in the art would understand that the steps of this method may be performed by the processing unit in the switched capacitor balancing and characterization system or in the battery system using the features of the switched capacitor balancing and characterization system or the battery system.

A person skilled in the art would understand also the reversed, i.e. the described method may be performed by the presently disclosed switched capacitor balancing and characterization system (100).

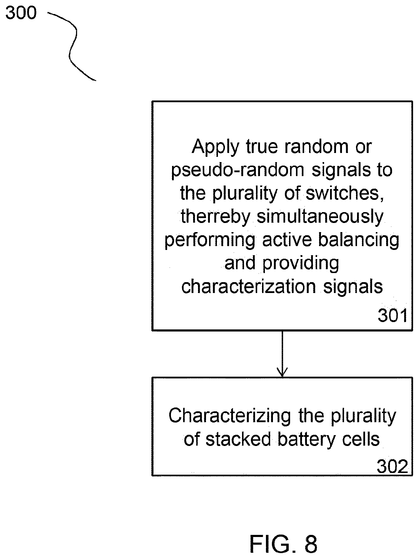

Fig. 8 shows a schematic diagram of an embodiment of the presently disclosed method for balancing and characterizing a plurality of stacked battery cells by using a switched-capacitor balancing and characterizing system.

The characterization signals at the output of the battery cells are generated as a consequence of applying the true random or pseudo random or noise signal to the clock of the switches of the switched capacitor balancing and characterization system. The characterization signals may then be fed to a characterization unit to obtain the characterization of the battery cells.

*Characterization*

The processing unit of the presently disclosed switched capacitor balancing and characterization system can control the switches generating a true random or pseudo random or noise control signal that achieves balancing of the battery stacks and also produces the characterization voltage and current at the output of the battery cells, which may be referred to as characterization signals. The processing unit is configured to control the plurality of switches by applying true random or pseudo-random control signals to the plurality of switches. "Applying true random or pseudo-random control signals to the plurality of switches" means that the switching period lengths of the control signals to the switches have a random component. Examples of possible implementations of such random components are provided below.

When the true random or pseudo-random control signals are applied to the plurality of switches, charge is moved from the more charged battery cells to the less charged battery cells over time. At the same time, the random or pseudo-random pattern can be used in the process of characterizing the stacked battery cells. In order to characterize a battery cell, characterization voltage(s) and/or current(s) are measured at terminals of the battery cell. As an example, ac-characteristics can be obtained by measuring the ac voltage or noise voltage across the battery cell. An internal impedance of the battery cell can be obtained by studying the voltage across the battery cell and the current through the battery cell. In the example of fig. 1 one battery cell (106) has an upper terminal (105) and lower terminal (107). The terminals (105; 107) are both "inputs" and "outputs" of the battery cell in the sense that a rechargeable battery cell can be seen both as an energy source and an energy. Hence, by "providing characterization voltage and/or current at terminals of the plurality of stacked battery cells", the presently disclosed method and system provide signals that can be measured and processed to characterize the stacked battery cells.

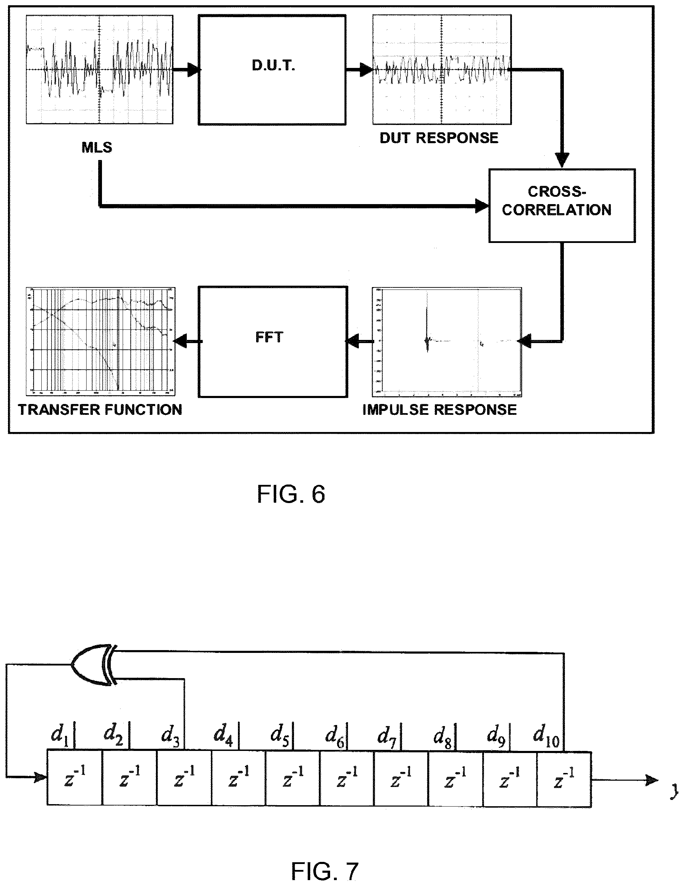

In one embodiment, the characterization signals may be used to characterize the battery cells in a way that would be understood by the person skilled in the art and that would comprise several methodologies, including the minimum length sequence or pseudo random noise which is often used for characterization of, for example, loudspeakers. Another methodology that the characterization unit may use is the Electrochemical Impedance Spectroscopy. In another embodiment the characterization unit may implement the steps shown as an example in Fig. 6 where a Fourier transform of the correlation between an input and output signal is used for full characterization of the battery cells.

In one embodiment of the presently disclosed switched capacitor balancing and characterization system, the characterization unit is configured to characterize the plurality of the stacked battery cells using a cross correlator between the input and the output voltage of at least one of the plurality of stacked battery cells and a Fourier transform of the signal generated by the correlation of the input and output voltage of at least one of the plurality of stacked battery cells.

The present disclosure further relates to, according to one embodiment, a switched capacitor balancing and characterization system, wherein the characterization unit is configured to characterize the AC impedance of the battery cells.

In one embodiment of the presently disclosed switched capacitor balancing and characterization system, the characterization unit uses the output voltage of at least one of the plurality of stacked battery cells to perform electrochemical impedance spectroscopy of the battery cells.

In one embodiment of the presently disclosed switched capacitor balancing and characterization system, further comprising an analyzer configured to correlate the applied true random or pseudo-random input signal to the output voltage or current of one or more of the plurality of stacked battery cells to characterize the impedance of the one or more of the plurality of stacked battery cells.

The present disclosure further relates to, according to one embodiment, a switched capacitor balancing and characterization system, further comprising a voltage measurement and/or a current measurement device for measuring a voltage or current of one or more of the plurality of stacked battery cells.

*True random or pseudo-random clock sequence*

The sequence of charging and discharging the capacitors in one of the embodiments of the present disclosure is programmed by the processing unit and, preferably, has a predetermined set of steps. The duration of each step may, however, be randomized using, in one embodiment, the random signal generated by a ring oscillator, a relaxation oscillator or crystal oscillator with excessive jitter introduced on top of this signal. The generation of the random signal may be achieved by several means and one of those could be the use of a resistor thermal noise which may be digitized to provide a random bit sequence.

According to one embodiment the true random or pseudo random control signal is generated using a monic polynomial. Monic polynomial in the context of the present disclosure may be of the type below:

$$P_{10}(x) = (x)^{10} + (x)^3 + 1$$

In one embodiment of the disclosed switched-capacitor balancing and characterization system, the clock signal used to switch the switches is generated by a sigma-delta converter. In this embodiment, the sigma-delta converter is generating a pseudo random sequence which may be used to modulate and randomize the duration of each step within the charging-discharging sequence of each of the possible schemes and configurations.

Fig. 7 shows an embodiment of a pseudo-random sequence generator that may be used for the generation of a pseudo-random sequence for the clock of the switches. In other embodiments pseudo-random binary sequence generators may be used to obtain a pseudo-random bit sequence. In a further embodiment the pseudo-random binary sequence may be implemented with linear feedback shift registers.

The random periodization of each of the steps of a given sequence may be achieved by randomizing the duty cycle of the clock or by using a fixed minimum base duration and randomize the number of minimum base duration intervals that each step of the sequence may have. For example, the minimum base duration could be set to one microsecond and the duration of step A of the sequence may be a random integer multiple of the base duration, whereas the duration of step B may be a random integer multiple of the minimum base duration, where A and B are predetermined steps of the sequence and correspond to predetermined configurations of the switches.

The present disclosure further relates to, according to one embodiment, the switched-capacitor balancing and characterization system, wherein the processing unit is configured to clock the switches using the true random or pseudo-random control signals.

For simultaneous balancing and characterization of the stack of battery cells the present disclosure utilizes a true random or pseudo random or noise signal for clocking the switches. The control signal, which can be said to include a random component, thus not only achieves balancing of the battery cells, but also generates the AC voltage and current on the battery cells which are used for AC characterization of the battery cells themselves.

The sequence that determines the configuration of the switches is pre-determined, and it could be a regular sequence where charge is moved from one battery cell to another battery cell, or it could be a boost scheme configuration where charged is transferred by one or more battery cells to a battery cell. The duration of each step of the sequence may be randomized or pseudo randomized by use of a random signal generated by the processing unit and used to clock the switches of the switched capacitor balancing and characterization unit. By randomizing the clock and therefore not having a deterministic clock with a 50% duty cycle it is possible to achieve simultaneous balancing and characterization of the battery cells, because charge is eventually transferred from the mostly charged battery cells to the least charged battery cells and at the same time generation of the characterization measurable voltage and current on the battery cells is simultaneously achieved.

The present disclosure further relates to, according to one embodiment, the switched capacitor balancing and characterization system, wherein the switched capacitor balancing and characterization system is configured to operate in a first mode, wherein the switches are clocked using a predefined duty cycle, such as 50%, and in a second mode, wherein the true random or pseudo-random control signals are applied to the plurality of switches. The processing unit can be programmed for generating a 50% duty cycle clock for the switches in a first mode. With a 50% duty cycle of the clock, balancing of the battery cells can be achieved. In a second mode, the processing unit is programmed to generate a true random or pseudo random or noise clock signal to the switches, this way achieving simultaneous balancing and generation of the characterization signals that a characterization unit can use for characterization of the battery cells.

In one embodiment of the presently disclosed switched capacitor balancing and characterization system, the processing unit is configured to switch the switches according to a number of predetermined charging steps in a predetermined order, and wherein the duration of each step has a random component.

The switched capacitor balancing and characterization system may further comprise a ring oscillator, or a relaxation oscillator, or a crystal oscillator, or a pseudo-random sequence generator, or a random noise generator, or a sigma-delta converter for generating the control signals to the plurality of switches. In another embodiment the randomization of the clock signal may be applied to randomize the intensity of the input signal to the batteries for each configuration of the circuit during the sequence. This may be achieved with a random switch conductance value either by selecting a random number of switch fingers to turn on, or by varying the switch driving voltage. This way the speed at which each capacitor is being charged and then discharged may be randomized achieving simultaneous balancing and characterization of the battery cells.

*List of elements in figures*

100 - Switched-capacitor balancing and characterization system for balancing and characterization of a plurality of stacked battery cells

101 - Capacitors connectable to the plurality of stacked battery cells

102 - Plurality of switches configured to connect and disconnect the at least one capacitor to the plurality of stacked battery cells

103 - Processing unit configured to control the plurality of switches

104 - One of the plurality of switches

105 - Upper terminal of one of the battery cells

106 - One of the battery cells

107 - Lower terminal of one of the battery cells

108 - Plurality of battery cells

109 - Characterization unit

110 - One of the capacitors

111 - Upper terminal of a capacitor

112 - Lower terminal of a capacitor

200 - Battery system

300 - Method for balancing and characterizing a plurality of stacked battery cells

**Claims**

1. A switched-capacitor balancing and characterization system (100) for balancing and characterization of a plurality of stacked battery cells (106), the switched-capacitor balancing and characterizing system comprising:

   - at least one capacitor (110) connectable to the plurality of stacked battery cells, wherein the at least one capacitor is adapted to move charge to and from the plurality of stacked battery cells;
   - a plurality of switches (104) configured to connect and disconnect the at least one capacitor to the plurality of stacked battery cells; and
   - a processing unit (103, 109) configured to control the plurality of switches by applying true random or pseudo-random control signals to the plurality of switches, wherein the processing unit is configured to control the plurality of switches such that switching period lengths of the control signals have a random component thereby simultaneously performing active balancing of the plurality of stacked battery cells and providing characterization voltage and/or current at terminals of the plurality of stacked battery cells.

2. The switched capacitor balancing and characterization system according to any one of the preceding claims, wherein the switched capacitor balancing and characterization system is configured to operate in a first mode, wherein the switches are clocked using a predefined duty cycle, such as 50%, and in a second mode, wherein the true random or pseudo-random control signals are applied to the plurality of switches.

3. The switched capacitor balancing and characterization system according to any one of the preceding claims, further comprising a voltage measurement and/or a current measurement device for measuring a voltage or current of one or more of the plurality of stacked battery cells.

4. The switched capacitor balancing and characterization system according to any one of the preceding claims, further comprising an analyzer configured to correlate the applied true random or pseudo-random control signals to the voltage or current of one or more of the plurality of stacked battery cells to characterize the impedance of the one or more of the plurality of stacked battery cells.

5. The switched capacitor balancing and characterization system according to any one of the preceding claims, further comprising a characterization unit (109) configured to characterize the plurality of the stacked battery cells using a cross correlator between the input and the output voltage of at least one of the plurality of stacked battery cells and a Fourier transform of the signal generated by the correlation of the input and output voltage of at least one of the plurality of stacked battery cells.

6. The switched capacitor balancing and characterization system according to claim 5, wherein the characterization unit is configured to characterize the AC impedance of the battery cells.

7. The switched capacitor balancing and characterization system according to any one of claims 5-6, wherein the characterization unit is configured to use the output voltage of at least one of the plurality of stacked battery cells to perform electrochemical impedance spectroscopy of the battery cells.

8. The switched capacitor balancing and characterization system according to any one of the preceding claims, wherein the processing unit is configured to, in a boost switching scheme, configure the plurality of switches to connect the capacitor to at least two serially connected battery cells.

9. The switched capacitor balancing and characterization system according to claim 8, wherein the processing unit is configured to configure the plurality of switches such that the capacitor is subsequently discharged to one of the two serially connected battery cells.

10. The switched capacitor balancing and characterization system according to claim 8, wherein the processing unit is configured to configure the plurality of switches such that the capacitor is subsequently discharged to the at least two serially connected battery cells.

11. The switched capacitor balancing and characterization system according to any one of claims 8-10, wherein the processing unit is configured to configure the plurality of switches such that the capacitor after each charge is alternatively discharged to the serially connected battery cells.

**12.** The switched capacitor balancing and characterization system according to any one of claims 8-11, wherein the switched capacitor balancing and characterization system is configured to operate in a first charging configuration, wherein each of the capacitors is alternatively connected to two neighboring serially connected battery cells, and, in the boost switching scheme, charging the capacitor using two or more serially connected battery cells.

**13.** The switched capacitor balancing and characterization system according to any one of the preceding claims, wherein the switched capacitor balancing and characterization system is configured to perform simultaneous balancing and characterization of the plurality of the stacked battery cells.

**14.** A method for balancing and characterizing a plurality of stacked battery cells by using a switched-capacitor balancing and characterizing system according to any one of claims 1-13, the method comprising the steps of:

- applying true random or pseudo-random control signals to the plurality of switches, wherein the switching period lengths of the control signals have a random component, thereby simultaneously performing active balancing of the plurality of stacked battery cells and providing characterization voltage and/or current at terminals of the plurality of stacked battery cells;
- characterizing the plurality of stacked battery cells by analyzing at least one characteristic of an electrical signal of the plurality of stacked battery cells.

**15.** A computer program having instructions which, when executed by a computing device or computing system, cause the computing device or computing system to carry out the method for balancing and characterizing a plurality of stacked battery cells according to claim 14.

**Patentansprüche**

**1.** System (100) zum Ausgleich und zur Charakterisierung eines Schaltkondensators zum Ausgleichen und zur Charakterisierung einer Vielzahl von gestapelten Batteriezellen (106), wobei das System zum Ausgleich und zur Charakterisierung eines Schaltkondensators Folgendes umfasst:

- mindestens einen Kondensator (110), der mit der Vielzahl von gestapelten Batteriezellen verbunden werden kann, wobei der mindestens eine Kondensator angepasst ist, um Ladung zu und von der Vielzahl von gestapelten Batteriezellen zu bewegen;
- eine Vielzahl von Schaltern (104), die dazu konfiguriert ist, den mindestens einen Kondensator mit der Vielzahl von gestapelten Batteriezellen zu verbinden und von diesen zu trennen; und
- eine Verarbeitungseinheit (103, 109), die dazu konfiguriert ist, die Vielzahl von Schaltern zu steuern, durch Anlegen echter zufälliger oder pseudozufälliger Steuersignale an die Vielzahl von Schaltern, wobei die Verarbeitungseinheit dazu konfiguriert ist, die Vielzahl von Schaltern so zu steuern dass die Schaltperiodenlängen der Steuersignale eine zufällige Komponente aufweisen, wodurch gleichzeitig aktives Ausgleichen der Vielzahl von gestapelten Batteriezellen durchgeführt wird und Charakterisierungsspannung und/oder -strom an Anschlüssen der Vielzahl von gestapelten Batteriezellen bereitgestellt wird.

**2.** System zum Abgleich und zur Charakterisierung eines Schaltkondensators nach einem der vorhergehenden Ansprüche, wobei das System zum Abgleich und zur Charakterisierung eines Schaltkondensators dazu konfiguriert ist, in einem ersten Modus betrieben zu werden, wobei die Schalter unter Verwendung eines vordefinierten Arbeitszyklus, wie z. B. 50 %, getaktet werden, und in einem zweiten Modus, wobei die echten zufälligen oder pseudozufälligen Steuersignale an die Vielzahl von Schaltern angelegt werden.

**3.** System zum Ausgleich und zur Charakterisierung eines Schaltkondensators nach einem der vorhergehenden Ansprüche, ferner umfassend eine Spannungsmessung- und/oder eine Strommessungsvorrichtung zum Messen einer Spannung oder eines Stroms von einer oder mehreren der Vielzahl von gestapelten Batteriezellen.

**4.** System zum Abgleich und zur Charakterisierung eines Schaltkondensators nach einem der vorhergehenden Ansprüche, ferner umfassend einen Analysator, der dazu konfiguriert ist, die angelegten echten zufälligen oder pseudozufälligen Steuersignale mit der Spannung oder dem Strom einer oder mehrerer der Vielzahl von gestapelten Batteriezellen zu korrelieren, um die Impedanz der einen oder mehreren der Vielzahl von gestapelten Batteriezellen zu charakterisieren.

**5.** System zum Abgleich und zur Charakterisierung eines Schaltkondensators nach einem der vorhergehenden Ansprüche, ferner umfassend eine Charakterisierungseinheit (109), die dazu konfiguriert ist, die Vielzahl von gestapelten Batteriezellen zu charakterisieren, unter Verwendung eines Kreuzkorrelators zwischen der Eingabe- und der Ausgangsspannung mindestens einer der Vielzahl von gestapelten Batteriezellen und einer Fouriertransformation des durch die Korrelation der Eingabe- und Ausgangsspannung mindestens einer der Vielzahl von gestapelten Batteriezellen erzeugten Signals.

6. System zum Abgleich und zur Charakterisierung eines Schaltkondensators nach Anspruch 5, wobei die Charakterisierungseinheit dazu konfiguriert ist, die AC-Impedanz der Batteriezellen zu charakterisieren.

7. System zum Ausgleich und zur Charakterisierung eines Schaltkondensators nach einem der Ansprüche 5-6, wobei die Charakterisierungseinheit dazu konfiguriert ist, die Ausgangsspannung von mindestens einer der Vielzahl von gestapelten Batteriezellen zu verwenden, um eine elektrochemische Impedanzspektroskopie der Batteriezellen durchzuführen.

8. System zum Ausgleich und zur Charakterisierung eines Schaltkondensators nach einem der vorhergehenden Ansprüche, wobei die Verarbeitungseinheit dazu konfiguriert ist, die Vielzahl von Schaltern in einem Boost-Schaltschema dazu zu konfigurieren, den Kondensator mit mindestens zwei in Reihe geschalteten Batteriezellen zu verbinden.

9. System zum Ausgleich und zur Charakterisierung eines Schaltkondensators nach Anspruch 8, wobei die Verarbeitungseinheit dazu konfiguriert ist, die Vielzahl von Schaltern so zu konfigurieren, dass der Kondensator nachfolgend auf eine der zwei in Reihe geschalteten Batteriezellen entladen wird.

10. System zum Ausgleich und zur Charakterisierung eines Schaltkondensators nach Anspruch 8, wobei die Verarbeitungseinheit dazu konfiguriert ist, die Vielzahl von Schaltern so zu konfigurieren, dass der Kondensator nachfolgend auf die mindestens zwei in Reihe geschalteten Batteriezellen entladen wird.

11. System zum Ausgleich und zur Charakterisierung eines Schaltkondensators nach einem der Ansprüche 8-10, wobei die Verarbeitungseinheit dazu konfiguriert ist, die Vielzahl von Schaltern so zu konfigurieren, dass der Kondensator nach jeder Ladung abwechselnd zu den seriell verbundenen Batteriezellen entladen wird.

12. System zum Ausgleich und zur Charakterisierung eines Schaltkondensators nach einem der Ansprüche 8-11, wobei das System zum Ausgleich und zur Charakterisierung eines Schaltkondensators dazu konfiguriert ist, in einer ersten Ladekonfiguration betrieben zu werden, wobei jeder der Kondensatoren abwechselnd mit zwei benachbarten in Reihe geschalteten Batteriezellen verbunden ist, und wobei, in dem Boost-Schaltschema, der Kondensator unter Verwendung von zwei oder mehr in Reihe geschalteten Batteriezellen geladen wird,

13. System zum Ausgleich und zur Charakterisierung eines Schaltkondensators nach einem der vorhergehenden Ansprüche, wobei das System zum Ausgleich und zur Charakterisierung eines Schaltkondensators dazu konfiguriert ist, den gleichzeitigen Ausgleich und die Charakterisierung der Vielzahl von gestapelten Batteriezellen durchzuführen.

14. Verfahren zum Ausgleichen und Charakterisieren einer Vielzahl von gestapelten Batteriezellen unter Verwendung eines Systems zum Ausgleich und zur Charakterisierung eines Schaltkondensators nach einem der Ansprüche 1-13,
wobei das Verfahren die folgenden Schritte umfasst:

- Anlegen echter zufälliger oder pseudozufälliger Steuersignale an die Vielzahl von Schaltern, wobei die Schaltperiodenlängen der Steuersignale eine zufällige Komponente aufweisen, wodurch gleichzeitig aktives Ausgleichen der Vielzahl von gestapelten Batteriezellen durchgeführt wird und Charakterisierungsspannung und/oder -strom an Anschlüssen der Vielzahl von gestapelten Batteriezellen bereitgestellt wird;
- Charakterisieren der Vielzahl von gestapelten Batteriezellen durch Analysieren mindestens einer Eigenschaft eines elektrischen Signals der Vielzahl von gestapelten Batteriezellen.

15. Computerprogramm, das Anweisungen aufweist, die, wenn sie von einer Rechenvorrichtung oder einem Rechensystem ausgeführt werden, die Rechenvorrichtung oder das Rechensystem veranlassen, das Verfahren zum Ausgleichen und Charakterisieren einer Vielzahl von gestapelten Batteriezellen nach Anspruch 14 durchzuführen.

**Revendications**

1. Système d'équilibrage et de caractérisation de condensateur commuté (100) pour l'équilibrage et la caractérisation d'une pluralité de cellules de batterie empilées (106), le système d'équilibrage et de caractérisation de condensateur commuté comprenant :

- au moins un condensateur (110) pouvant être connecté à la pluralité de cellules de batterie empilées, dans lequel l'au moins un condensateur est conçu pour déplacer la charge vers et depuis la pluralité de cellules de batterie empilées ;

- une pluralité de commutateurs (104) configurés pour connecter et déconnecter l'au moins un condensateur de la pluralité de cellules de batterie empilées ; et

- une unité de traitement (103, 109) configurée pour commander la pluralité de commutateurs en appliquant des signaux de commande aléatoires ou pseudo-aléatoires véritables à la pluralité de commutateurs, dans lequel l'unité de traitement est configurée pour commander la pluralité de commutateurs de sorte que les longueurs de période de commutation des signaux de commande ont une composante aléatoire, exécutant ainsi simultanément un équilibrage actif de la pluralité de cellules de batterie empilées et fournissant une tension et/ou un courant de caractérisation aux bornes de la pluralité de cellules de batterie empilées.

2. Système d'équilibrage et de caractérisation de condensateur commuté selon l'une quelconque des revendications précédentes, dans lequel le système d'équilibrage et de caractérisation de condensateur commuté est configuré pour fonctionner dans un premier mode, dans lequel les commutateurs sont cadencés à l'aide d'un cycle de service prédéfini, tel que 50 %, et dans un second mode, dans lequel les signaux de commande aléatoires ou pseudo-aléatoires véritables sont appliqués à la pluralité de commutateurs.

3. Système d'équilibrage et de caractérisation de condensateur commuté selon l'une quelconque des revendications précédentes, comprenant également un dispositif de mesure de tension et/ou de mesure de courant pour mesurer une tension ou un courant d'une ou de plusieurs de la pluralité de cellules de batterie empilées.

4. Système d'équilibrage et de caractérisation de condensateur commuté selon l'une quelconque des revendications précédentes, comprenant également un analyseur configuré pour corréler les signaux de commande aléatoires ou pseudo-aléatoires appliqués à la tension ou au courant d'une ou de plusieurs de la pluralité de cellules de batterie empilées pour caractériser l'impédance d'une ou de plusieurs de la pluralité de cellules de batterie empilées.

5. Système d'équilibrage et de caractérisation de condensateur commuté selon l'une quelconque des revendications précédentes, comprenant également une unité de caractérisation (109) configurée pour caractériser la pluralité de cellules de batterie empilées à l'aide d'un corrélateur croisé entre la tension d'entrée et de sortie d'au moins une de la pluralité de cellules de batterie empilées et une transformée de Fourier du signal généré par la corrélation de la tension d'entrée et de sortie d'au moins une de la pluralité de cellules de batterie empilées.

6. Système d'équilibrage et de caractérisation de condensateur commuté selon la revendication 5, dans lequel l'unité de caractérisation est configurée pour caractériser l'impédance CA des cellules de batterie.

7. Système d'équilibrage et de caractérisation de condensateur commuté selon l'une quelconque des revendications 5 et 6, dans lequel l'unité de caractérisation est configurée pour utiliser la tension de sortie d'au moins une de la pluralité de cellules de batterie empilées pour exécuter une spectroscopie d'impédance électrochimique des cellules de batterie.

8. Système d'équilibrage et de caractérisation de condensateur commuté selon l'une quelconque des revendications précédentes, dans lequel l'unité de traitement est configurée pour, dans un schéma de commutation de suralimentation, configurer la pluralité de commutateurs pour connecter le condensateur à au moins deux cellules de batterie connectées en série.

9. Système d'équilibrage et de caractérisation de condensateur commuté selon la revendication 8, dans lequel l'unité de traitement est configurée pour configurer la pluralité de commutateurs de sorte que le condensateur est ensuite déchargé vers l'une des deux cellules de batterie connectées en série.

10. Système d'équilibrage et de caractérisation de condensateur commuté selon la revendication 8, dans lequel l'unité de traitement est configurée pour configurer la pluralité de commutateurs de sorte que le condensateur est ensuite déchargé vers les au moins deux cellules de batterie connectées en série.

11. Système d'équilibrage et de caractérisation de condensateur commuté selon l'une quelconque des revendications 8 à 10, dans lequel l'unité de traitement est configurée pour configurer la pluralité de commutateurs de sorte que le condensateur après chaque charge est déchargé en alternance vers les cellules de batterie connectées en série.

12. Système d'équilibrage et de caractérisation de condensateur commuté selon l'une quelconque des revendications 8 à 11, dans lequel le système d'équilibrage et de caractérisation de condensateur commuté est configuré pour fonctionner dans une première configuration de charge, dans lequel chacun des condensateurs est connecté en alternance à deux cellules de batterie voisines connectées en série, et, dans le schéma de commutation de suralimentation, chargeant le condensateur à l'aide de deux cellules de batterie connectées en série ou plus.

13. Système d'équilibrage et de caractérisation de condensateur commuté selon l'une quelconque des revendications précédentes, dans lequel le système d'équilibrage et de caractérisation de condensateur commuté est configuré pour exécuter un équilibrage et une caractérisation simultanés de la pluralité de cellules de batterie empilées.

14. Procédé d'équilibrage et de caractérisation d'une pluralité de cellules de batterie empilées à l'aide d'un système d'équilibrage et de caractérisation de condensateur commuté selon l'une quelconque des revendications 1 à 13,

le procédé comprenant les étapes suivantes :

- l'application de signaux de commande aléatoires ou pseudo-aléatoires véritables à la pluralité de commutateurs, dans lequel les durées de période de commutation des signaux de commande ont une composante aléatoire, exécutant ainsi simultanément un équilibrage actif de la pluralité de cellules de batterie empilées et fournissant une tension et/ou un courant de caractérisation aux bornes de la pluralité de cellules de batterie empilées ;
- la caractérisation de la pluralité de cellules de batterie empilées en analysant au moins une caractéristique d'un signal électrique de la pluralité de cellules de batterie empilées.

15. Programme informatique ayant des instructions qui, lorsqu'elles sont exécutées par un dispositif informatique ou un système informatique, amènent le dispositif informatique ou le système informatique à mettre en œuvre le procédé d'équilibrage et de caractérisation d'une pluralité de cellules de batterie empilées selon la revendication 14.

FIG. 1

FIG. 2

FIG. 3A

FIG. 3B

FIG. 3C

FIG. 3D

FIG. 4

FIG. 5A

FIG. 5B

FIG. 5C

FIG. 5D

FIG. 6

FIG. 7

300

Apply true random or pseudo-random signals to the plurality of switches, therreby simultaneously performing active balancing and providing characterization signals

301

Characterizing the plurality of stacked battery cells

302

FIG. 8

FIG. 9A

FIG. 9B

FIG. 10A

FIG. 10B

FIG. 10C

FIG. 10D

**EP 4 268 346 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2002190692 A

- WO 2020142398 A